# FASCICULE DE BREVET EUROPEEN

(11) **EP 2 633 102 B1**
(45) Date de publication et mention de la délivrance du brevet: **16.09.2020**
(21) Numéro de dépôt: 11782179.3
(22) Date de dépôt: 24.10.2011
(51) Int. Cl.: C30B 7/08, C30B 29/48, C30B 29/60, B82Y 30/00, B82Y 40/00, H01L 31/0296, H01L 31/032, H01L 31/0352, H01L 33/18

(54) **NANOFEUILLETS COLLOÏDAUX et leur utilisation**
KOLLOIDALE NANOSHEETS und deren Verwendung
COLLOIDAL NANOSHEETS and their use

(30) Priorité: 25.10.2010 FR 1004175
(43) Date de publication de la demande: 04.09.2013
(73) Titulaire: Nexdot, 93230 Romainville (FR)
(72) Inventeur: MAHLER, Benoit, 93230 Romainville (FR); ITHURRIA, Sandrine, 93230 Romainville (FR)
(74) Mandataire: Icosa
(86) Numéro de dépôt international: PCT/FR2011/000570
(87) Numéro de publication internationale: WO 2012/056121

(56) Documents cités:
- EP-A2- 2 163 301
- SANDRINE ITHURRIA ET AL: "Quasi 2D Colloidal CdSe Platelets with Thicknesses Controlled at the Atomic Level", JOURNAL OF THE AMERICAN CHEMICAL SOCIETY, AMERICAN CHEMICAL SOCIETY, WASHINGTON, DC; US, vol. 130, no. 49, 1 janvier 2008 (2008-01-01), pages 16504-16505, XP002573191, ISSN: 0002-7863, DOI: 10.1021/JA807724E [extrait le 2008-11-14] cité dans la demande
- ZHANG A ET AL: "Nanocrystalline metal chalcogenides obtained open to air: synthesis, morphology, mechanism, and optical properties", JOURNAL OF PHYSICAL CHEMISTRY C AMERICAN CHEMICAL SOCIETY USA, vol. 113, no. 35, 10 août 2009 (2009-08-10), pages 15492-15496, XP002657881, ISSN: 1932-7447, DOI: DOI:10.1021/JP900367D
- GEORGIOS N KARANIKOLOS ET AL: "Water-based synthesis of ZnSe nanostructures using amphiphilic block copolymer stabilized lyotropic liquid crystals as templates", NANOTECHNOLOGY, IOP, BRISTOL, GB, vol. 17, no. 13, 14 juillet 2006 (2006-07-14), pages 3121-3128, XP020103838, ISSN: 0957-4484, DOI: 10.1088/0957-4484/17/13/007

## Description

### Domaine technique de l'invention

La présente invention concerne un matériau nanocristallin sous forme de feuillets par exemple obtenus par croissance latérale de nanocristaux ou nanofeuillets initiaux réalisée par introduction continue de précurseurs pendant une durée prédéterminée. L'invention concerne également l'utilisation des nanocristaux obtenus.

### État de l'art :

La fabrication de structures présentant au moins une dimension nanométrique induit l'apparition de propriétés physiques nouvelles. Ces nanostructures présentent des caractéristiques qui peuvent notablement différer de celles du matériau massif. On assiste en particulier à une modification des propriétés électroniques¹, optiques, magnétiques² ou plasmoniques³ des matériaux lorsque leurs dimensions sont réduites jusqu'à l'échelle nanométrique. Ces nouveaux matériaux suscitent ainsi un intérêt qui va croissant dans des domaines aussi variés que l'optique, l'électronique ou la catalyse.

Les nanocristaux colloïdaux de semiconducteurs en particulier sont des objets très étudiés depuis le début des années quatre-vingt. Ceux-ci voient leurs propriétés optiques se modifier lorsque leur taille atteint des dimensions nanométriques^{4,5}. Leur absorbance se décale vers le bleu et ils deviennent fluorescents à une longueur d'onde dépendant uniquement de la taille de la particule considérée. En effet, en dessous d'une certaine taille (définie par le rayon de Bohr excitonique du matériau), les effets de confinement quantique se font sentir et l'énergie de bande interdite du semiconducteur augmente quand la taille diminue⁶. Pour le CdSe par exemple, le rayon de Bohr excitonique est de 56 Angström et l'énergie de la bande interdite correspond à 710nm pour le matériau massif. Ainsi, pour des tailles inférieures à 10nm de diamètre, les nanocristaux de CdSe fluorescent dans le bleu (2nm de diamètre), le vert (3nm de diamètre), l'orange (4nm de diamètre) ou le rouge (6nm de diamètre)⁷. La spectroscopie devient alors un outil privilégié pour caractériser ces objets ; la taille moyenne et la dispersion en taille d'un ensemble de particules sont accessibles directement en réalisant un spectre d'absorbance ou d'émission de l'échantillon.

Ces objets sont toujours synthétisés suivant le même schéma : le découplage des étapes de nucléation et de croissance des nanocristaux⁸. Pour cela, une solution de précurseurs est en général injectée rapidement au sein d'un ballon rempli d'un mélange de solvants organiques coordinants et/ou non-coordinants porté à haute température (250-350°C)⁹. La nucléation a alors lieu durant un temps très court, celle-ci entraînant une forte chute de la concentration accompagnée par une baisse de la température. Les précurseurs restant en solution permettent aux nuclei de croître jusqu'à consommation totale de ceux-ci.

Jusqu'à récemment, les nanocristaux synthétisés selon cette technique étaient toujours sphériques. L'obtention de structures anisotropes, de type bâtonnets¹⁰ ou tétrapodes¹¹ par exemple, a fait l'objet de recherches intensives ces 10 dernières années et a permis d'enrichir fortement la zoologie des formes accessibles par ce type de synthèse.

Suivant la géométrie des nanocristaux, il est possible d'observer plusieurs types de confinement : tridimensionnel dans le cas d'un nanocristal sphérique (point quantique) et bidimensionnel dans le cas d'un nano-fil. Ne manquait à cette liste que les objets présentant un confinement unidimensionnel. Celui-ci apparaitrait pour des objets d'épaisseur faible (quelques nanomètres, inférieur au rayon de Bohr) et de dimensions latérales d'au moins un ordre de grandeur supérieur (au moins 10nm par exemple pour CdSe). Dans la suite, ces objets seront désignés sous le nom de nanofeuillets.

Dans ce contexte, les nanofeuillets sont une nouvelle classe de nano-matériaux présentant des propriétés physiques particulièrement intéressantes. Ces objets, si leur épaisseur est atomiquement contrôlée présentent un confinement quantique unidimensionnel uniquement (dans l'épaisseur), ce qui induit :
- une fluorescence très étroite spectralement¹²
- des temps de vie de fluorescence très courts
- une section efficace d'absorption très importante.

De plus, la possibilité de synthétiser ces feuillets avec des dimensions latérales supérieures au micron ouvrirait la voie à de nouvelles applications. En effet, la création par chimie douce de films ultra-minces de semiconducteurs permettrait leur application en photovoltaïque, en électronique (transistors à effet de champ par exemple) ou encore en optique.

La synthèse colloïdale de nano-feuillets a connu un fort développement depuis le début des années 2000. Il est possible de distinguer plusieurs types de synthèses, chacun associé à un ensemble de matériaux différents. Les principales approches existantes, qui seront détaillées dans la suite, sont l'exfoliation directe d'un matériau lamellaire, la croissance de nano-feuillets par empoisonnement (ce qui bloque la croissance) de certaines faces cristallines par des ligands, et enfin le passage par un composé intermédiaire de structure lamellaire subissant une transformation topotactique.

L'exfoliation directe est utilisée couramment afin de produire des feuillets de graphène, d'hydroxides ou d'oxydes (TiO₂ par exemple). Le mode de préparation consiste généralement à diminuer l'énergie d'interaction entre les feuillets afin de les séparer mécaniquement par la suite.

Une stratégie utilisée pour les composés ioniques consiste à provoquer un gonflement de l'espace inter-feuillets (contenant généralement des ions positifs) en réalisant un échange des cations par un ion fortement encombré tel que le tetrabutyl ammonium hydroxide¹³. Ce gonflement affaiblit les interactions entre les feuillets qui peuvent alors être séparés mécaniquement par sonication par exemple.

Dans le cas du graphite, la diminution de l'énergie d'interaction interfeuillets peut être réalisée par l'utilisation d'un solvant adéquat tel que le N-methylpyrrolidone¹⁴.
Ce type de procédé conduit toujours à l'obtention de mono-feuillets de quelques Angström d'épaisseur. Il n'y a pas de croissance possible, la dimension des feuillets dépend de la dimension de l'objet massif exfolié. Un contrôle de l'épaisseur du nanofeuillet est également inenvisageable, celle-ci est fixée par la structure lamellaire du composé de départ et donc par sa nature chimique.

Une approche beaucoup plus versatile, permettant de fabriquer des nanofeuillets de nature très variée consiste en l'empoisonnement de certaines facettes cristallines par les ligands de surface adéquats. L'adsorption préférentielle de molécules sur certaines faces cristallines du matériau considéré bloque la croissance dans les directions perpendiculaires à ces facettes et induit alors une croissance cristalline fortement anisotrope^{15,16}. Ce procédé est très largement utilisé pour obtenir des nanobatonnets par exemple. Il est à noter que la molécule empoisonnante peut être de nature très variée :
- tensio-actifs¹⁷
- polymères¹⁸
- thiols¹⁹
- amines²⁰⁻²²
- ions inorganiques^{20,23}
Les matériaux ainsi synthétisés peuvent être :
- des nano plaquettes de metaux (PVP^{18,24,25}, CTAB²⁶, ions^{20,23})
- des oxydes de terres rares^{22,27} (oleic acid oleylamine)
- des sulfures (Cu2S¹⁹ aux Thiols) ...

Ce mode de fabrication, bien qu'étant extrêmement général, possède tout de même certaines limitations. Il est en effet impossible de contrôler finement l'épaisseur des feuillets obtenus et d'obtenir un ensemble de feuillets présentant tous la même épaisseur (monodispersité en épaisseur). De plus, il n'a pas été rapporté à notre connaissance la possibilité de réaliser une extension latérale ultérieure de ces matériaux.

Il est enfin possible de synthétiser des nanofeuillets en tirant parti de la formation d'un intermédiaire lui-même lamellaire. Cette approche peut être mise à profit afin de réaliser des nanofeuillets de métaux (Cobalt, Nickel ou Cuivre²⁸) ou d'oxydes (oxyde de magnésium MgO²⁹) en passant par un hydroxyde lamellaire. De même, de nombreux chalcogènes lamellaires sont obtenus par formation préalable d'un complexe Metal-(amine primaire) de structure lamellaire qui réagit ultérieurement avec un précurseur de soufre ou de selenium. Il est ainsi possible de former des feuillets de CdSe³⁰, de CdMnSe³¹, de ZnS³²⁻³⁵, ou encore d'In₂S₃³⁶. Il est a noter qu'un complexe plomb-thiourée lamellaire permet également la formation de nanofeuillets de PbS³⁷.

Ce dernier type de procédé a permis pour la première fois d'obtenir des feuillets de chalcogènes dont l'épaisseur est définie à la monocouche atomique près³⁰. Mais encore une fois, le contrôle de l'épaisseur reste impossible et il n'as pas été rapporté la possibilité d'une croissance latérale ultérieure de ces objets.

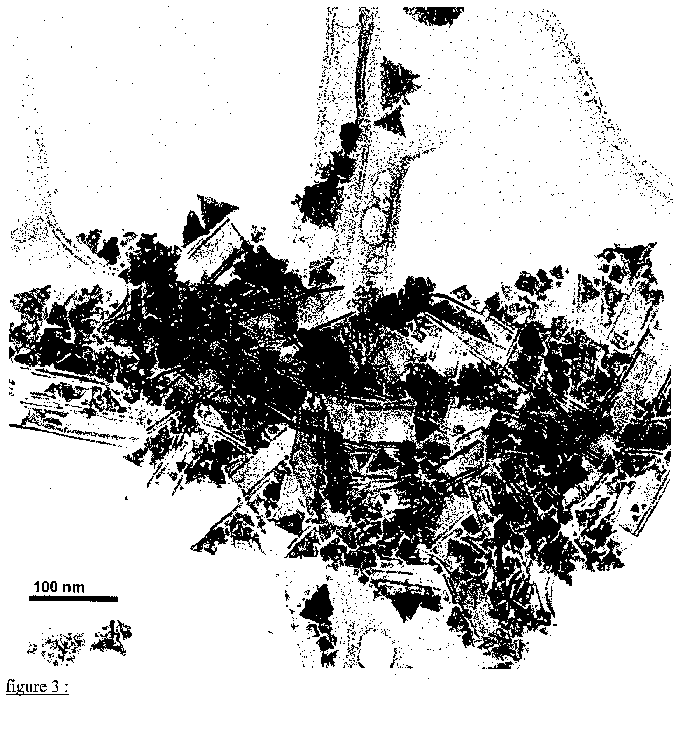

Un protocole de synthèse de nano-plaquettes de CdSe a récemment été rapporté¹² consistant en l'injection rapide d'un sel d'acétate au sein d'un milieu réactionnel chaud contenant du Sélénium en poudre et un carboxylate de cadmium. La formation de nano-plaquettes est rapide et s'accompagne de la formation indésirable de quantum-dots (nanocristaux colloïdaux isotropes).
En s'inspirant des protocoles disponibles dans la littérature^{12,38}, des essais de synthèse de nanofeuillets de CdSe de grandes dimensions latérales ont été effectués. Tels que décrits, les protocoles ne sont pas adaptables pour obtenir des nanofeuillets purs. En particulier, pour obtenir des nanofeuillets de grandes dimensions, le brevet cité³⁸ décrit une étape de croissance latérale dans laquelle des plaquettes ainsi que des précurseurs sont présents initialement dans le milieu réactionnel. Ces synthèses conduisent systématiquement à la formation parasite de quantités importantes de nanocristaux de CdSe isotropes ainsi que de nanostructures d'oxyde de cadmium (voir figure 3). Des modifications importantes, décrites dans la suite, ainsi qu'un changement de paradigme sont donc nécessaires pour développer des protocoles de synthèse de nanofeuillets de grandes dimensions latérales exempts d'objets parasites.

En conclusion, les connaissances actuelles dans la synthèse de nanofeuillets ne permettent pas de synthétiser des objets à la fois d'épaisseur contrôlée à la monocouche atomique près et dont les dimensions latérales sont réglables du nanomètre au micron.

### Exposé de l'invention :

Selon un premier aspect la présente invention concerne un nanofeuillet colloïdal par exemple obtenu par croissance latérale sur un nanocristal colloïdal initial, d'un matériau cristallin semiconducteur représenté par la formule MₙX_{y} M étant un métal de transition et X un chalcogène, le procédé comprenant les étapes suivantes :
la préparation d'une première solution organique non ou faiblement coordinante constituant un solvant de synthèse et contenant ledit nanocristal colloïdal initial ;
la préparation d'une deuxième solution organique contenant des précurseurs de M et de X et contenant en outre un sel d'acétate ; et
l'introduction progressive pendant une durée prédéterminée d'une quantité prédéterminée de la deuxième solution dans une quantité prédéterminée de la première solution, à une température prédéterminée T pour la croissance du nanofeuillet.

Un autre procédé de fabrication d'un matériau cristallin semiconducteur sous forme de feuillets représenté par la formule MₙX_{y} M étant un métal de transition et X un chalcogène, peut comprendre les étapes suivantes :
la préparation d'une première solution organique non ou faiblement coordinante constituant un solvant de synthèse; la préparation d'une deuxième solution organique contenant des précurseurs de M et de X et contenant en outre un sel d'acétate ; et
l'introduction progressive pendant une durée prédéterminée d'une quantité prédéterminée de la deuxième solution dans une quantité prédéterminée de la première solution, à une température prédéterminée T pour la formation du nanofeuillet.

Le nano feuillet colloïdal de la présente invention, comme décrit dans la revendication 1, comprend un nanocristal colloidal semiconducteur initial entouré latéralement par un matériau cristallin semi-conducteur différent.
- Le nanocristal colloïdal initial est composé de CdO, CdS, CdSe, CdTe, ZnO, ZnS, ZnSe, ZnTe, PbO, PbS, PbSe, PbTe, GeS, GeSe, SnS, SnSe, GeS₂, GeSe₂, SnS₂, SnSe₂, HgS, HgSe, HgTe, CuInS₂, CuInSe₂, AgInS₂, AgInSe₂, CuS, Cu₂S, Ag₂S, Ag₂Se, Ag₂Te, FeS, FeS₂, InP, Cd₃P₂, Zn₃P₂, FeO, Fe₂O₃, Fe₃O₄, Al₂O₃, TiO et des alliages de ceux-ci.
- Le nanocristal colloïdal initial est un nanofeuillet colloïdal.
- Le matériau cristallin semiconducteur MₙX_{y} est choisi parmi CdO, CdS, CdSe, CdTe, ZnO, ZnS, ZnSe, ZnTe, PbO, PbS, PbSe, PbTe, GeS, GeSe, SnS, SnSe, GeS₂, GeSe₂, SnS₂, SnSe₂, HgS, HgSe, HgTe, CuInS₂, CuInSe₂, AgInS₂, AgInSe₂, CuS, Cu₂S, Ag₂S, Ag₂Se, Ag₂Te, FeS, FeS₂, InP, Cd₃P₂, Zn₃P₂, FeO, Fe₂O₃, Fe₃O₄, Al₂O₃, TiO₂ et les alliages de ceux-ci.
- Le matériau cristallin semiconducteur MₙX_{y} est dopé par un métal de transition.
- Le nanofeuillet colloïdal obtenu présente des dimensions latérales supérieures à 10nm.
- Le nanofeuillet colloïdal obtenu présente une épaisseur comprise entre 0.3nm et 100nm.
- Le nanofeuillet colloïdal obtenu est homogène en composition.
- Le nanofeuillet colloïdal obtenu est hétérogène en composition, le nanocristal initial étant de composition différente par rapport au matériau MₙX_{y} déposé.
- Le nanofeuillet colloïdal obtenu est utilisé afin de former des films ultra-minces semiconducteurs sur substrat à basse température.
- Le nanofeuillet colloïdal obtenu est utilisé en tant que élément actif de diodes électroluminescentes, transistors ou lasers.
- Le nanofeuillet colloïdal obtenu est utilisé en tant que matériau à grande surface spécifique pour la catalyse.
- Le nanofeuillet colloïdal obtenu est utilisé en tant que matériau d'électrodes.
- Le nanofeuillet colloïdal obtenu est utilisé en tant que élément actif d'un module photovoltaïque : absorbeur et/ou collecteur.

D'autres caractéristiques et avantages du procédé selon l'invention apparaîtront à la lecture de la description détaillée des exemples de réalisation à titre d'illustration non limitative et faite en référence aux dessins annexés dans lesquels :

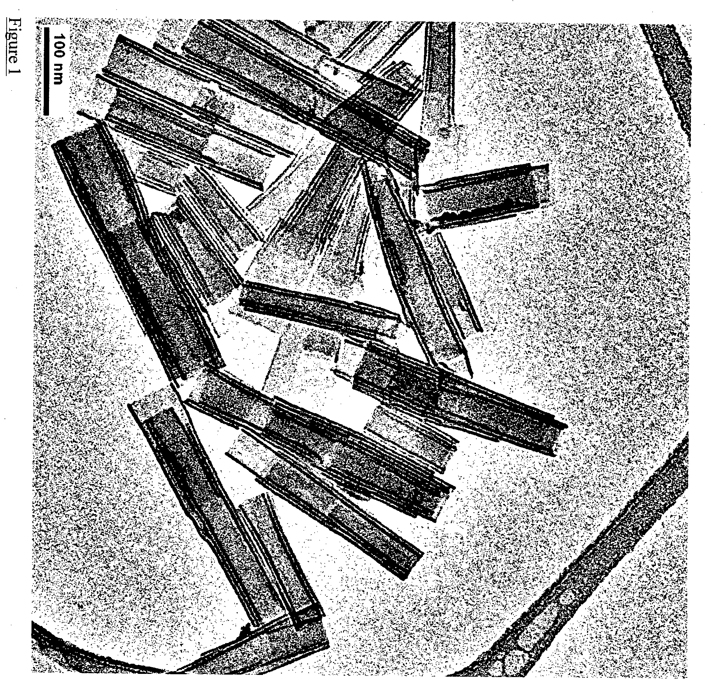

- la figure 1 montre des feuillets de CdSe enroulés émettant à 462nm synthétisés d'après l'exemple 1 d'un mode de réalisation de l'invention

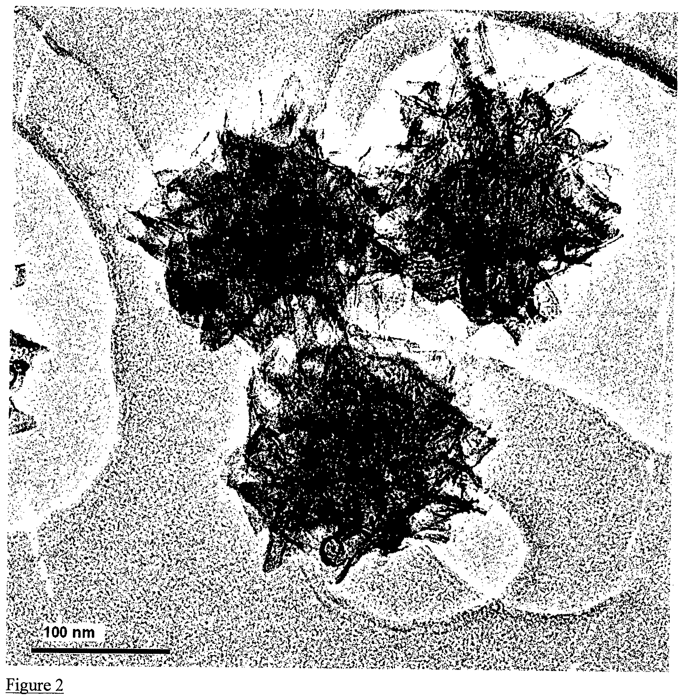

- la figure 2 montre des Feuillets de CdSe agrégés émettant à 393nm
- la figure 3 montre des_Feuillets de CdSe émettant à 462nm synthétisés selon une modification de l'exemple 1 quand tout l'acétate de cadmium est dans le ballon uniquement.
- la figure 4 montre la structure schématique d'un feuillet hétérogène en composition vu du dessus.

### Description détaillée:

Des modes de réalisation de l'invention qui seront décrits par la suite présentent des méthodes de croissance bidimensionnelle de nanocristaux semiconducteurs. Ces procédés permettent d'atteindre des dimensions latérales supérieures au micron tandis que l'épaisseur des nanofeuillets est maintenue constante, contrôlée à la monocouche atomique près. Il est également possible de contrôler l'épaisseur des nanofeuillets obtenus en contrôlant certains des paramètres de synthèse tels que la nature des précurseurs, la température de réaction et/ou la présence de nanocristaux au sein du milieu réactionnel.

Ces procédés de croissance selon des modes de réalisation de l'invention peuvent permettre l'obtention, sans traitement post-synthétique de séparation, de nanofeuillets purs, exempts de nanocristaux isotropes parasites.

Le nouveau procédé de croissance cristalline exposé s'oppose du paradigme "nucléation/croissance par injection rapide des précurseurs à chaud" qui est actuellement utilisé dans toutes les synthèses organiques de nanocristaux semiconducteurs colloïdaux. En effet, dans le mode de synthèse selon des modes de réalisation de l'invention les précurseurs sont introduits lentement dans le ballon. Le taux de nucléation est régi par la température du ballon et la vitesse d'injection ; le système se dirige vers un état de croissance à l'équilibre dans lequel tous les précurseurs injectés sont consommés pour la croissance des feuillets, la nucléation initiale permet l'existence au sein du milieu réactionnel de suffisamment de germes pour consommer à tout instant les précurseurs introduits. La taille finale des nanofeuillets (ses dimensions latérales) est ainsi régie par la quantité de précurseurs introduits.

De plus, le mode de croissance proposé s'oppose également aux descriptions de synthèses de nanofeuillets par la méthode dite de "soft templating" dans lesquelles un complexe lamellaire présent en solution (rôle pouvant être joué par le sel d'acétate) guide la croissance vers la formation de nanofeuillets. Dans des modes de réalisation de l'invention, une solution de précurseurs comprenant un sel d'acétate finement broyé et bien dispersé est introduite lentement dans le milieu réactionnel, qui peut être simplement un solvant organique chaud sans sel d'acétate.

En contrôlant la température et la nature des précurseurs, il est donc possible de contrôler l'épaisseur des feuillets tandis que leur concentration est contrôlée par la vitesse d'injection et que les dimensions latérales sont contrôlées par la quantité de précurseurs introduits. La géométrie des feuillets est elle contrôlée en particulier par la nature du sel d'acétate utilisé.

Dans la suite, nous désignerons le composé binaire du matériau nanocristallin par la formule générale MX, M étant un métal de transition et X un chalcogène. Les feuillets pouvant être synthétisés par le procédé exposé sont CdO, CdS, CdSe, CdTe, ZnO, ZnS, ZnSe, ZnTe, PbO, PbS, PbSe, PbTe et l'ensemble de leurs alliages. Il est également possible de fabriquer ces mêmes matériaux dopés au Fe, Cu, Mn, Mg, Co.....

La synthèse consiste en l'introduction lente de précurseurs de M et de X ainsi que d'un sel d'acétate dans un ballon contenant un solvant organique non ou faiblement coordinant ainsi que des nanocristaux germes.

Afin d'obtenir une croissance bidimensionnelle un sel d'acétate est utilisé. Celui-ci peut-être de n'importe quelle nature, l'utilisation de différents sels d'acétates permet l'obtention de différentes géométries de feuillets. Il est à noter que dans le cas de CdSe, l'utilisation d'acétate de cadmium permet l'obtention de feuillets carrés.

Pour les résultats obtenus l'acétate est broyé finement au mortier et dispersé dans la solution à introduire. Dans ce cas, la synthèse est contrôlée et ne donne plus lieu à l'apparition de composés parasites tels que des nanocristaux isotropes ou bien des oxydes induits par la décomposition thermique de l'acétate. Il est ainsi possible d'obtenir des nanofeuillets de très grandes dimensions latérales, supérieures au micron, ce qui est impossible si le sel d'acétate est directement présent dans le milieu réactionnel. En effet, dans ce cas, celui-ci se dégrade au fur et à mesure de la synthèse qui n'aboutit alors pas à la formation de grands nanofeuillets purs.

Le précurseur de M généralement utilisé est un carboxylate de M réalisé à partir d'un acide gras. Le précurseur de M peut également être un acétate de M. Plus précisément, le précurseur de M peut être un oléate de M, un stéarate de M ou un myristate de M.

Le précurseur de X peut être toute forme liquide contenant X ou encore une dispersion homogène de poudre de X. Plus précisément, le précurseur de X peut être X dissous dans une phosphine (trioctylphosphine, tributylphosphine, triphenylphosphine...) à des concentration allant de 0.1M à stoechiometrique ou encore X dissous dans un alcène tels que le 1-octadécène à des concentration allant de 0.01M à 0.2M. Le précurseur de X peut également être sous degré d'oxydation -2 tel que H₂X ou Na₂X

Le solvant de synthèse peut être tout solvant organique non ou peu coordinant. Plus précisément, le solvant peut être du 1-octadécène, de la trioctylamine, du toluène ou encore du benzylbenzoate.

La température du ballon lors de l'introduction des précurseurs peut être comprise entre 20°C et 250°C. Elle dépend de la nature des précurseurs et de l'épaisseur des feuillets que l'on souhaite synthétiser. En particulier, la température peut-être située entre 150°C et 200°C.

La synthèse se déroule sous atmosphère inerte (Argon, azote) de préférence, pour éviter la formation parasite d'oxydes, mais il est possible de la réaliser à l'air.

### Exemples :

L'invention sera décrite en référence aux exemples suivants, données à titre illustratif non-limitatif.

### Exemple 1 : Synthèse de nanofeuillets émettant à 462nm

Dans un ballon tricol de 100ml, sont introduit 10mL d'1-octadécène (ODE) ainsi que 40mg de Cd(acétate)₂,2H₂O broyé préalablement au mortier. Le mélange est placé sous agitation magnétique à dégazer sous vide durant 30 minutes. Le milieu réactionnel est alors inerté à l'argon et chauffé à 180°C.

Dans le même temps, un mélange de 40mg de Cd(acétate)₂,2H₂O broyé préalablement au mortier, de 240mg de Cd(myristate)₂ et de 4mL de trioctylamine est chauffé sous agitation jusqu'à dissolution complète du Cd(myristate)₂. 4mL d'une solution de Sélénium dans l'ODE à 0.1M y est alors ajouté. En refroidissant, le mélange forme un gel.

Ce gel est injecté en 2 heures à 180°C dans le milieu réactionnel, causant l'apparition puis la croissance de nanofeuillets de plus de 200nm de dimensions latérales.

### Exemple 2 : croissance de nanofeuillets émettant à 510nm

Dans un ballon tricol de 100ml, sont introduit 10mL d'1-octadécène (ODE), 40mg de Cd(acétate)₂,2H₂O broyé préalablement au mortier ainsi que 10 nmol de nanocristaux de CdSe synthétisés selon la méthode décrite en référence¹². Le mélange est placé sous agitation magnétique à dégazer sous vide durant 30 minutes. Le milieu réactionnel est alors inerté à l'argon et chauffé à 180°C.

Dans le même temps, un mélange de 40mg de Cd(acétate)₂,2H₂O broyé préalablement au mortier, de 240mg de Cd(myristate)₂ et de 4mL de trioctylamine est chauffé sous agitation jusqu'à dissolution complète du Cd(myristate)₂. 4mL d'une solution de Sélénium dans l'ODE à 0.1M y est alors ajouté. En refroidissant, le mélange forme un gel.

Ce gel est injecté en 4 heures à 200°C dans le milieu réactionnel, causant la croissance de nanofeuillets de plus de 100nm de dimensions latérales.

### Dans un autre mode de réalisation de l'invention :

Dans un ballon tricol de 100ml, sont introduit 10mL d'1-octadécène (ODE) ainsi que 10nmol de nanocristaux de CdSe synthétisés selon la méthode décrite en référence¹². Le mélange est placé sous agitation magnétique à dégazer sous vide durant 30 minutes. Le milieu réactionnel est alors inerté à l'argon et chauffé à 240°C.

Dans le même temps, on prépare un mélange de 96mg de Cd(acétate)₂,2H₂O dissous dans 1mL d'éthanol, 46µL d'acide oléique, 1mL de butanol et 4mL d'une solution de Sélénium dans l'ODE à 0.1M.

Cette solution est injectée en 30 minutes à 240°C dans le milieu réactionnel, causant la croissance de nanofeuillets de plus de 100nm de dimensions latérales.

### Exemple 3 : synthèse de nanofeuillets émettant à 393nm

10mL de toluène est introduit dans un ballon tricol de 100mL. Celui-ci est chauffé à 100°C tandis qu'une seringue contenant 5mL de toluène, 133mg de Cd(acétate)₂, 30mg de d'acide benzoïque ainsi que 100µL de TOPSe stoechiometrique est préparée.

La seringue est alors injectée en 1 heure, à raison de 5mL par heure dans le ballon de toluène chaud.

Le mélange réactionnel se trouble lentement, indiquant la formation de grands nanofeuillets émettant à 393nm.

Ceux-ci sont séparés du milieu réactionnel par centrifugation et resuspendus dans le toluène.

Le nouveau mode de fabrication de nanocristaux selon les modes de réalisation présentés permet de contrôler l'épaisseur de régler les dimensions latérales des nanofeuillets obtenues, ce qui ouvre la voie à des applications nouvelles de ces matériaux dans des domaines aussi variés que le photovoltaïque, l'électronique et l'optique.

Les dimensions latérales sont contrôlées par la quantité de précurseurs introduits tandis que l'épaisseur est contrôlée par les paramètres de synthèse : température, nature des précurseurs ainsi que présence initiale de nanocristaux au sein du milieu réactionnel.

Il a été remarqué que le mode de préparation des nanofeuillets selon des modes de réalisation exposés minimise la formation de nanocristaux et minimise les réactions parasites de décomposition des sels d'acétate. En particulier, une injection lente de l'ensemble des précurseurs ainsi que du sel d'acétate en poudre fine permet d'éviter totalement les réactions parasites telles que la formation de nanocristaux et permet donc l'obtention de nanofeuillets purs.

### Exemple 4 : croissance de nanofeuillets cœur/couronne CdSe/CdS :

Dans un ballon tricol de 100ml, sont introduit 10mL d'1-octadécène (ODE) ainsi que 10nmol de nanocristaux de CdSe synthétisés selon la méthode décrite en référence¹². Le mélange est placé sous agitation magnétique et est dégazé sous vide durant 30 minutes. Le milieu réactionnel est alors placé sous atmosphère d'argon et chauffé à 240°C.

Dans le même temps, on prépare un mélange de 96mg de Cd(acétate)₂,2H₂O dissous dans 1mL d'éthanol, 46µL d'acide oléique, 1mL de butanol et 4mL d'une solution de Soufre dans l'ODE à 0.1M.

Cette solution est injectée en 30 minutes à 240°C dans le milieu réactionnel, causant la croissance de nanofeuillets cœur/couronne CdSe/CdS de plus de 50nm de dimensions latérales.

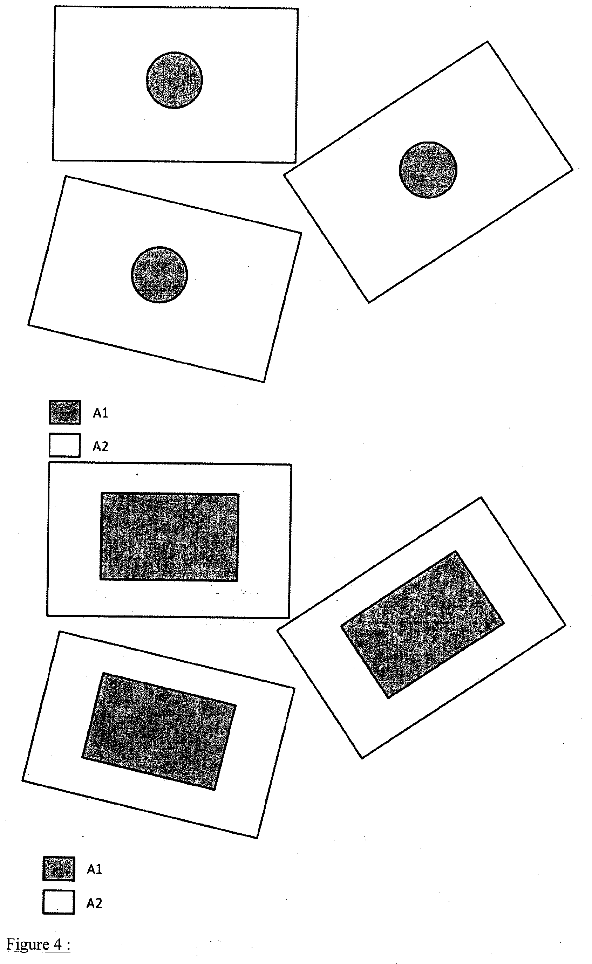

La structure de ces feuillets cœur/couronne est schématisée figure 4, où A1 est le CdSe et A2 est le CdS.

### Bibliographie

(1) Ekimov, A. I.; Onushchenko, A. A. Jetp Lett. 1981, 34, 345-349.
(2) Vassiliou, J. K.; Mehrotra, V.; Russell, M. W.; Giannelis, E. P.; McMichael, R. D.; Shull, R. D.; Ziolo, R. F. J. Appl. Phys. 1993, 73, 5109-5116.
(3) El-Sayed, M. A. Accounts Chem. Res. 2001, 34, 257-264.
(4) Rossetti, R.; Nakahara, S.; Brus, L. E. Journal of Chemical Physics 1983, 79, 1086-1088.
(5) Ekimov, A. I.; Onushchenko, A. A. Jetp Lett. 1984, 40, 1136-1139.
(6) Efros, A. L.; Rosen, M. Annu. Rev. Mater. Sci. 2000, 30, 475-521.
(7) Yu, W. W.; Qu, L.; Guo, W.; Peng, X. Chemistry of Materials 2003, 15, 2854-2860.
(8) Jongnam Park, J. J., Soon Gu Kwon, Youngjin Jang, Taeghwan Hyeon, Angewandte Chemie International Edition 2007, 46, 4630-4660.
(9) Murray, C. B.; Norris, D. J.; Bawendi, M. G. Journal of the American Chemical Society 1993, 115, 8706-8715.
(10) Peng, X. G.; Manna, L.; Yang, W. D.; Wickham, J.; Scher, E.; Kadavanich, A.; Alivisatos, A. P. Nature 2000, 404, 59-61.
(11) Manna, L.; Scher, E. C.; Alivisatos, A. P. Journal of the American Chemical Society 2000, 122, 12700-12706.
(12) Ithurria, S.; Dubertret, B. Journal of the American Chemical Society 2008, 130, 16504-16505.
(13) Sasaki, T.; Watanabe, M. Journal of Physical Chemistry B 1997, 101, 10159-10161.
(14) Hernandez, Y.; Nicolosi, V.; Lotya, M.; Blighe, F. M.; Sun, Z.; De, S.; McGovern, I. T.; Holland, B.; Byrne, M.; Gun'Ko, Y. K.; Boland, J. J.; Niraj, P.; Duesberg, G.; Krishnamurthy, S.; Goodhue, R.; Hutchison, J.; Scardaci, V.; Ferrari, A. C.; Coleman, J. N. NatNano 2008, 3, 563-568.
(15) Kumar, S.; Nann, T. Small 2006, 2, 316-329.
(16) Young-wook Jun, J.-s. C., Jinwoo Cheon, Angewandte Chemie International Edition 2006, 45, 3414-3439.
(17) Xu, S. L.; Sun, X.; Ye, H.; You, T.; Song, X. Y.; Sun, S. X. Materials Chemistry and Physics 2010, 120, 1-5**.**
(18) Li, C.; Cai, W.; Cao, B.; Sun, F.; Li, Y.; Kan, C.; Zhang, L. Advanced Functional Materials 2006, 16, 83-90.
(19) Sigman, M. B.; Ghezelbash, A.; Hanrath, T.; Saunders, A. E.; Lee, F.; Korgel, B. A. Journal of the American Chemical Society 2003, 125, 16050-16057.
(20) Deng, Z. T.; Mansuipur, M.; Muscat, A. J. Journal of Physical Chemistry C 2009, 113, 867-873.
(21) Puntes, V. F.; Zanchet, D.; Erdonmez, C. K.; Alivisatos, A. P. Journal of the American Chemical Society 2002, 124, 12874-12880.
(22) Si, R.; Zhang, Y. W.; You, L. P.; Yan, C. H. Angew. Chem.-Int. Edit. 2005, 44, 3256-3260.
(23) Zhang, G.; Sun, S.; Li, R.; Zhang, Y.; Cai, M.; Sun, X. Chemistry ofMaterials 2010, 22, 4721-4727.
(24) Sun, Y.; Xia, Y. Science 2002, 298, 2176-2179.
(25) Ah, C. S.; Yun, Y. J.; Park, H. J.; Kim, W. J.; Ha, D. H.; Yun, W. S. Chemistry of Materials 2005, 17, 5558-5561.
(26) Huang, W. L.; Chen, C. H.; Huang, M. H. Journal of Physical Chemistry C 2007, 111, 2533-2538.
(27) Yu, T.; Joo, J.; Park, Y. I.; Hyeon, T. Journal of the American Chemical Society 2006, 128, 1786-1787.
(28) Xu, R.; Xie, T.; Zhao, Y. G.; Li, Y. D. Cryst. Growth Des. 2007, 7, 1904-1911.
(29) Yu, J. C.; Xu, A. W.; Zhang, L. Z.; Song, R. Q.; Wu, L. Journal of Physical Chemistry B 2004, 108,64-70*.*
(30) Joo, J.; Son, J. S.; Kwon, S. G.; Yu, J. H.; Hyeon, T. Journal of the American Chemical Society 2006, 128, 5632-5633.
(31) Yu, J. H.; Liu, X.; Kweon, K. E.; Joo, J.; Park, J.; Ko, K.-T.; Lee, D. W.; Shen, S.; Tivakornsasithorn, K.; Son, J. S.; Park, J.-H.; Kim, Y.-W.; Hwang, G. S.; Dobrowolska, M.; Furdyna, J. K.; Hyeon, T. **2010,** *9,* 47-53.
(32) Yu, S. H.; Yoshimura, M. Advanced Materials 2002, 14, 296-+.
(33) Li, J. P.; Xu, Y.; Wu, D.; Sun, Y. H. Solid State Communications 2004, 130, 619-622.
(34) Yao, W. T.; Yu, S. H.; Pan, L.; Li, J.; Wu, Q. S.; Zhang, L.; Jiang, H. Small 2005, 1, 320-325.
(35) Fan, L. B.; Song, H. W.; Zhao, H. F.; Pan, G. H.; Yu, H. Q.; Bai, X.; Li, S. W.; Lei, Y. Q.; Dai, Q. L.; Qin, R. F.; Wang, T.; Dong, B.; Zheng, Z. H.; Ren, X. G. Journal of Physical Chemistry B 2006, 110, 12948-12953.
(36) Park, K. H.; Jang, K.; Son, S. U. Angewandte Chemie International Edition 2006, 45, 4608-4612.
(37) Hu, H. M.; Deng, C. H.; Huang, X. H.; Li, Y.; Sun, M.; Zhang, K. H. Chin. J. Inorg. Chem. 2007, 23, 1403-1408.
(38) Dubertret, B.; Ithurria, S. US patent application n°, 61/095,978*.*

## Revendications

1. Un nanofeuillet colloïdal comprenant un nanocristal colloïdal semiconducteur initial entouré latéralement par un matériau cristallin semi-conducteur différent représenté par la formule MₙX_{y}, M étant un métal de transition et X un chalcogène ; ledit nanocristal colloïdal semiconducteur initial et ledit matériau cristallin semi-conducteur ayant la même épaisseur ; et lesdits nanocristal colloïdal initial et matériau cristallin semi-conducteur MₙX_{y} étant composés de CdO, CdS, CdSe, CdTe, ZnO, ZnS, ZnSe, ZnTe, PbO, PbS, PbSe, PbTe, GeS, GeSe, SnS, SnSe, GeS₂, GeSe₂, SnS₂, SnSe₂, HgS, HgSe, HgTe, CuInS₂, CuInSe₂, AgInS₂, AgInSe₂, CuS, Cu₂S, Ag₂S, Ag₂Se, Ag₂Te, FeS, FeS₂, InP, Cd₃P₂, Zn₃P₂, FeO, Fe₂O₃, Fe₃O₄, Al₂O₃, TiO₂ ou des alliages de ceux-ci.

2. Un nanofeuillet selon la revendication **1** dans lequel le matériau cristallin semi-conducteur MₙX_{y} est dopé par un métal de transition.

3. Un nanofeuillet selon l'une quelconque des revendications précédentes dans lequel le nanofeuillet colloïdal présente des dimensions latérales supérieures à 10 nm.

4. Un nanofeuillet selon l'une quelconque des revendications précédentes dans lequel le au moins un nanocristal colloïdal initial est un nanofeuillet colloïdal.

5. Utilisation de nanofeuillets colloïdaux selon l'une quelconque des revendications **1** à **4** en tant que matériau à grande surface spécifique pour la catalyse.

6. Utilisation de nanofeuillets colloïdaux selon l'une quelconque des revendications **1** à **4** dans un élément actif de diode électroluminescente, dans un transistor ou dans un laser.

7. Utilisation de nanofeuillets colloïdaux selon l'une quelconque des revendications **1** à **4** dans un élément actif d'un module photovoltaïque, en particulier dans un absorbeur et/ou dans un collecteur des charges photogénérés.

8. Utilisation de nanofeuillets colloïdaux selon l'une quelconque des revendications **1** à **4** pour former des films ultra-minces semiconducteurs sur substrat à basse température.

## Patentansprüche

1. Kolloidales Nanosheet, umfassend einen kolloidalen halbleitenden initialen Nanokristall, lateral umgeben von einem anderen halbleitenden kristallinen Material, dargestellt von der Formel MₙX_{y}, wobei M ein Transitionsmetall ist und X ein Chalkogen; wobei der kolloidale halbleitende initiale Nanokristall und das halbleitende kristalline Metall die gleiche Dicke aufweisen; und wobei der kolloidale anorganische initiale Nanokristall und das halbleitende kristalline Metall MₙX_{y} aus CdO, CdS, CdSe, CdTe, ZnO, ZnS, ZnSe, ZnTe, PbO, PbS, PbSe, PbTe, GeS, GeSe, SnS, SnSe, GeS₂, GeSe₂, SnS₂, SnSe₂, HgS, HgSe, HgTe, CuInS₂, CuInSe₂, AgInS₂, AgInSe₂, CuS, Cu₂S, Ag₂S, Ag₂Se, Ag₂Te, FeS, FeS₂, InP, Cd₃P₂, Zn₃P₂, FeO, Fe₂O₃, Fe₃O₄, Al₂O₃, TiO₂ oder aus Legierungen davon bestehen.

2. Nanosheet nach Anspruch **1,** in welchem das halbleitende kristalline Material MₙX_{y} von einem Transitionsmetall dotiert ist.

3. Nanosheet nach einem der vorhergehenden Ansprüche, in welchem das kolloidale Nanosheet laterale Maße über 10 nm aufweist.

4. Nanosheet nach einem der vorhergehenden Ansprüche, in welchem der wenigstens eine kolloidale initiale Nanokristall ein kolloidales Nanosheet ist.

5. Verwendung von kolloidalen Nanosheets nach einem der Ansprüche **1** bis **4** als großflächiges Material spezifisch für die Katalyse.

6. Verwendung von kolloidalen Nanosheets nach einem der Ansprüche **1** bis **4** in einem aktiven Element einer Leuchtdiode, in einem Transistor oder in einem Laser.

7. Verwendung von kolloidalen Nanosheets nach einem der Ansprüche **1** bis **4** in einem aktiven Element eines Photovoltaikmoduls, insbesondere in einem Absorber und/oder in einem Sammler von unter Lichteinwirkung erzeugten Ladungen.

8. Verwendung von kolloidalen Nanosheets nach einem der Ansprüche **1** bis **4** zum Bilden von ultradünnen halbleitenden Filmen auf einem Substrat bei niedriger Temperatur.

## Claims

1. A colloidal nanosheet comprising an initial colloidal semiconductor nanocrystal surrounded laterally by a different semiconductor crystalline material represented by the formula MₙX_{y}, wherein M is a transition metal and X is a chalcogen; wherein said initial colloidal semiconductor nanocrystal and said semiconductor crystalline material have the same thickness; and wherein said initial colloidal nanocrystal and semiconductor crystalline material MₙX_{y} are made of CdO, CdS, CdSe, CdTe, ZnO, ZnS, ZnSe, ZnTe, PbO, PbS, PbSe, PbTe, GeS, GeSe, SnS, SnSe, GeS₂, GeSe₂, SnS₂, SnSe₂, HgS, HgSe, HgTe, CuInS₂, CuInSe₂, AgInS₂, AgInSe₂, CuS, Cu₂S, Ag₂S, Ag₂Se, Ag₂Te, FeS, FeS₂, InP, Cd₃P₂, Zn₃P₂, FeO, Fe₂O₃, Fe₃O₄, Al₂O₃, TiO₂, or alloys thereof.

2. The nanosheet according to claim 1, wherein the semiconductor crystalline material MₙX_{y} is doped by a transition metal.

3. The nanosheet according to any one of the preceding claims, wherein the colloidal nanosheet has lateral dimensions larger than 10 nm.

4. The nanosheet according to any one of the preceding claims, wherein the initial colloidal nanocrystal is a colloidal nanosheet.

5. Use of colloidal nanosheets according to any one of claims **1** to **4** as a large specific area material for catalysis.

6. Use of colloidal nanosheets according to any one of claims **1** to **4** in an active element of a light emitting diode, in a transistor or in a laser.

7. Use of colloidal nanosheets according to any one of claims **1** to **4** in an active element of a solar cell, in particular in an absorber and or in a collector of photogenerated charges.

8. Use of colloidal nanosheets according to any one of claims **1** to **4** for forming semiconductor ultrathin films on a substrate at low temperature.
